# FASCICULE DE BREVET EUROPEEN

(11) **EP 3 378 102 B1**
(45) Date de publication et mention de la délivrance du brevet: **09.09.2020**
(21) Numéro de dépôt: 16795072.4
(22) Date de dépôt: 14.11.2016
(51) Int. Cl.: H01L 31/049

(54) **MODULE PHOTOVOLTAÏQUE LÉGER COMPORTANT UNE COUCHE AVANT EN VERRE OU POLYMÈRE ET UNE COUCHE ARRIÈRE EN RELIEF**
LEICHTES FOTOVOLTAIKMODUL MIT EINER VORDERSCHICHT AUS GLAS ODER POLYMER UND EINER HINTERSCHICHT MIT ERHÖHTEN ABSCHNITTEN
LIGHTWEIGHT PHOTOVOLTAIC MODULE INCLUDING A FRONT LAYER MADE FROM GLASS OR POLYMER AND A REAR LAYER COMPRISING RAISED PORTIONS

(30) Priorité: 16.11.2015 FR 1560986
(43) Date de publication de la demande: 26.09.2018
(73) Titulaire: Commissariat à l'Energie Atomique et aux Energies Alternatives, 75015 Paris (FR); EDF ENR PWT, Paris la Défense 92932 (FR)
(72) Inventeur: GAUME, Julien, 38110 La Tour Du Pin (FR); LEFILLASTRE, Paul, 75013 Paris (FR); GOAER, Gilles, 38307 Bourgoin-Jallieu (FR); LE QUANG, Nam, 38307 Bourgoin-Jallieu (FR); WILLIATTE, Samuel, 38307 Bourgoin-Jallieu (FR)
(74) Mandataire: Brevalex
(86) Numéro de dépôt international: PCT/EP2016/077594
(87) Numéro de publication internationale: WO 2017/085021

(56) Documents cités:
- EP-A1- 2 724 841
- WO-A1-2014/075919
- US-A1- 2007 074 755
- US-A1- 2011 017 275
- US-A1- 2012 174 967
- US-A1- 2012 199 176

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, étant particulièrement concernée par les applications qui requièrent l'utilisation de modules photovoltaïques légers, en particulier d'un poids par unité de surface inférieur ou égal à 7 kg/m², notamment inférieur ou égal à 6 kg/m², voire 5 kg/m², et présentant des propriétés de résistance mécanique respectant les normes IEC 61215 et IEC 61730. Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un module photovoltaïque comportant une première couche formant la face avant du module, réalisée en verre et/ou en matériau polymère, et une deuxième couche formant la face arrière du module, comprenant des reliefs sur sa surface externe, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

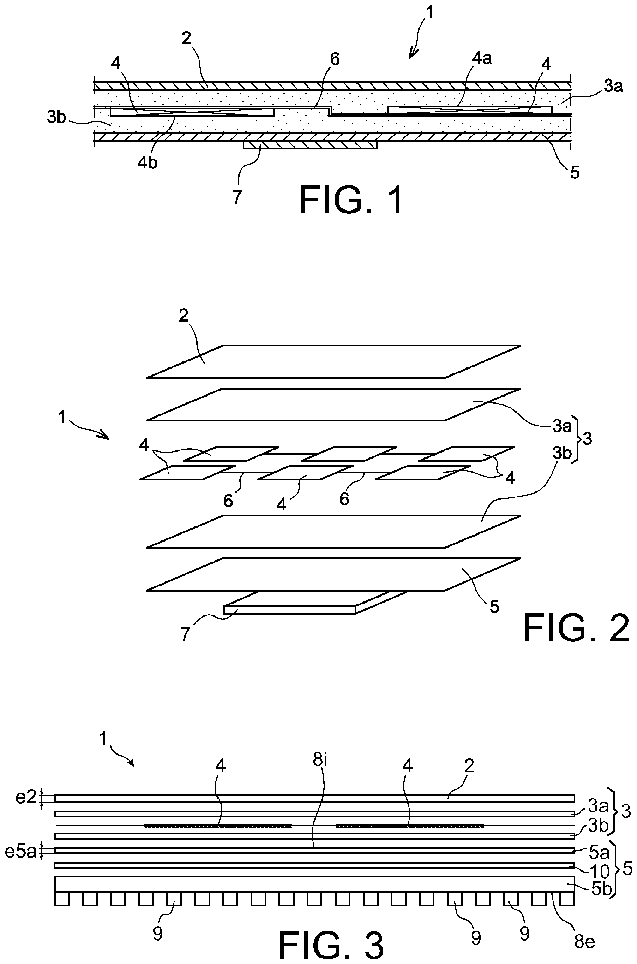

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 160°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais, lui permettant dans la majorité des cas de respecter les normes IEC 61215 et IEC 61730.

Néanmoins, un tel module photovoltaïque 1 selon la conception classique de l'art antérieur présente l'inconvénient d'avoir un poids élevé, en particulier un poids par unité de surface d'environ 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur. Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 3 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans de nouvelles applications exigeantes en termes de légèreté, il existe un besoin pour trouver une solution alternative à l'utilisation d'un verre d'épaisseur d'environ 3 mm en face avant du module.

Pour cela, des solutions ont été proposées dans la littérature brevet pour développer d'autres types de modules photovoltaïques légers et souples, dépourvus de cadre métallique, à partir de cellules à base de l'alliage CIGS (cuivre, indium, gallium et séléniure) ou à base de silicium à couche mince, tout en remplaçant le verre en face avant par des matériaux polymères plus légers et plus minces. On peut ainsi citer à ce titre la demande de brevet FR 2 955 051 A1, la demande de brevet américain US 2005/0178428 A1 ou encore les demandes internationales WO 2008/019229 A2 et WO 2012/140585 A1.

Les modules photovoltaïques obtenus possèdent un poids surfacique très inférieur à celui des modules photovoltaïques classiquement réalisés avec du verre épais en face avant. Cependant, leurs propriétés mécaniques ne sont pas suffisantes pour résister aux contraintes, notamment mécaniques, imposées en particulier par la norme IEC 61215.

D'autres solutions de l'art antérieur concernent l'utilisation d'un verre mince en face avant du module photovoltaïque. Ce verre mince peut être appliqué au module photovoltaïque à la condition d'avoir été préalablement « durci » grâce au procédé de trempe chimique. Il est alors possible d'obtenir de manière simple un gain de poids significatif. On peut ainsi citer à ce sujet les demandes internationales WO 2010/019829 A1, WO 2013/024738 A1 et WO 2008/139975 A1, ainsi que la demande de brevet européen EP 2 404 321 A1.

Toutefois, le simple remplacement du verre épais d'environ 3 mm d'épaisseur par un verre mince en face avant du module photovoltaïque a pour conséquence de dégrader les propriétés de résistance mécanique du module, de sorte que celui-ci ne possède plus une structure suffisante pour résister aux contraintes, notamment mécaniques, imposées en particulier par la norme IEC 61215.

Pour pallier à ce problème, certaines solutions prévoient alors de renforcer la face arrière du module photovoltaïque, pourvu d'un cadre métallique, à l'aide de traverses métalliques dans le but d'éviter sa flexion lorsqu'il est soumis à une charge mécanique. On peut ainsi citer par exemple la demande de brevet européen EP 2 702 613 A1.

Néanmoins, bien que ces solutions permettent de réduire le poids du module photovoltaïque tout en respectant les normes imposées sur les propriétés mécaniques, elles demandent un renfort important du cadre et le poids surfacique de ce type de module photovoltaïque reste supérieur à 7 kg/m² lorsque le verre mince utilisé présente une épaisseur supérieure ou égale à 1,1 mm.

Les documents WO2014075919 et US20120174967 divulguent des exemples connus de modules photovoltaïques légers présentant une structure de renforcement mécanique en face arrière.

### EXPOSÉ DE L'INVENTION

Il existe ainsi un besoin pour concevoir une solution alternative de module photovoltaïque prévu pour être suffisamment léger afin de s'adapter à certaines applications, tout en présentant des propriétés mécaniques lui permettant d'être conforme aux normes IEC 61215 et IEC 61730.

L'invention a pour but de remédier au moins partiellement aux besoins mentionnés précédemment et aux inconvénients relatifs aux réalisations de l'art antérieur. L'objet de l'invention est défini par la revendication 1 et un procédé réalisation selon l'invention est défini par la revendication 12.

L'invention a ainsi pour objet, selon l'un de ses aspects, un module photovoltaïque comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, la deuxième couche comportant une surface interne, au contact de l'ensemble encapsulant, et une surface externe, opposée à la surface interne, l'ensemble encapsulant et la pluralité de cellules photovoltaïques étant situés entre les première et deuxième couches, caractérisé en ce que la première couche est réalisée en verre et/ou en au moins un matériau polymère et présente une épaisseur inférieure ou égale à 1,1 mm, en ce que la surface interne de la deuxième couche est sensiblement plane,
et en ce que la deuxième couche comporte en outre des reliefs formant saillie relativement à la surface extérieure de la deuxième couche, la surface extérieure et les reliefs définissant ensemble la surface extérieure arrière visible du module photovoltaïque.

Ainsi, de façon avantageuse, le principe de l'invention consiste à la fois à remplacer le verre épais standard d'une épaisseur d'environ 3 mm, habituellement utilisé dans un module photovoltaïque classique, par une première couche plus mince en verre et/ou en au moins un matériau polymère, et à modifier la face arrière du module photovoltaïque pour prévoir la présence d'une structure tridimensionnelle comprenant des reliefs en saillie de la surface extérieure de la deuxième couche du module photovoltaïque. Autrement dit encore, la surface extérieure de la face arrière du module photovoltaïque est tridimensionnelle, par opposition aux surfaces extérieures bidimensionnelles des modules photovoltaïques selon l'art antérieur.

Comme il sera explicité par la suite au travers des modes de réalisation privilégiés de l'invention, la deuxième couche du module photovoltaïque peut être formée en une ou plusieurs parties, à savoir qu'elle peut consister en une seule et même couche, monocouche ou multicouche, comprenant lesdits reliefs ou en un ensemble comprenant au moins deux couches dont l'une comprend lesdits reliefs, chacune desdites au moins deux couches étant monocouche ou multicouche, et dont la réunion forme la deuxième couche. En particulier, la deuxième couche sous forme d'une seule partie peut consister en un renfort tridimensionnel disposé au contact de l'ensemble encapsulant, tandis que la deuxième couche sous forme de plusieurs parties peut consister en une première couche, monocouche ou multicouche, semblable à une couche formant la face arrière d'un module photovoltaïque selon la conception classique de l'art antérieur, et en une deuxième couche sous la forme d'un renfort tridimensionnel.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau d'encapsulation, réunies entre elles après lamination pour former l'ensemble encapsulant.

En effet, initialement, c'est-à-dire avant toute opération de lamination, l'ensemble encapsulant est constitué par au moins deux couches de matériau d'encapsulation, dites couches de cœur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Grâce à l'invention, il peut ainsi être possible d'obtenir un nouveau type de module photovoltaïque rigide, présentant un poids sensiblement inférieur à celui d'un module photovoltaïque classique tel que décrit précédemment, notamment pratiquement deux fois inférieur au poids d'un module classique, à savoir d'un poids inférieur ou égal à 7 kg/m², voire 6 kg/m², voire encore 5 kg/m², contre environ 12 kg/m² pour un module classique. De plus, le module photovoltaïque proposé par l'invention conserve des propriétés mécaniques équivalentes à celles des modules photovoltaïques traditionnels utilisant un verre épais d'environ 3 mm d'épaisseur en face avant.

Le module photovoltaïque selon l'invention peut en outre comporter l'une ou plusieurs des caractéristiques suivantes prises isolément ou suivant toutes combinaisons techniques possibles.

Ainsi, la première couche peut être réalisée en verre, et notamment en verre trempé, texturé ou non texturé.

La première couche peut encore être réalisée en au moins un matériau polymère, par exemple texturé ou non texturé, notamment choisi parmi : le polycarbonate (PC), le polyméthacrylate de méthyle (PMMA), notamment du PMMA monophasé (non choc) ou du PMMA multi-phasé (choc), par exemple du PMMA choc nanostructuré, tel que celui commercialisé par la société Altuglas® sous la marque Altuglas® Shield-Up®, le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytetrafluoroéthylène (PTFE) et/ou le polychlorotrifluoroéthylène (PCTFE).

Selon un premier mode de réalisation de l'invention, la deuxième couche peut être constituée par un ensemble d'au moins une première couche arrière, au contact de l'ensemble encapsulant, et une deuxième couche arrière tridimensionnelle de sorte que la première couche arrière est disposée entre l'ensemble encapsulant et la deuxième couche arrière, la surface interne de la deuxième couche étant formée par la surface interne, au contact de l'ensemble encapsulant, de la première couche arrière et la surface externe de la deuxième couche étant formée par la surface externe de la deuxième couche arrière, laquelle comporte les reliefs formant saillie relativement à ladite surface externe.

La deuxième couche peut en outre comporter une couche adhésive entre la première couche arrière et la deuxième couche arrière, pour permettre l'assemblage de la deuxième couche arrière à la première couche arrière.

Par « couche adhésive », on entend une couche permettant, une fois l'ensemble formé par la première couche, l'ensemble encapsulant, les cellules photovoltaïques et la première couche arrière réalisé, à la deuxième couche arrière d'adhérer à la première couche arrière. Il s'agit ainsi d'une couche permettant une compatibilité chimique et une adhésion entre la première couche arrière et la deuxième couche arrière. En particulier, la couche adhésive peut notamment être une colle silicone. La couche adhésive peut également être un adhésif sensible à la pression, également appelé PSA pour « Pressure Sensitive Adhesive » en anglais. Le PSA est composé d'une base d'élastomère possédant une résine pégueuse thermoplastique de faible masse moléculaire, par exemple de type ester. La base d'élastomère est par exemple un acrylique, un caoutchouc (butyle, naturel ou silicone), un nitrile, un copolymère à bloc styrène (SBC) (par exemple, styrène-butadiène-styrène (SBS), styrène-éthylène/butylène-styrène (SEBS), styrène-éthylène/propylène (SEP), styrène-isoprène-styrène (SIS)) ou un éther de vinyle. La base d'élastomère peut être également de l'éthylène-acétate de vinyle, ou EVA pour « Ethylene-Vinyl Acetate » en anglais, avec un taux élevé d'acétate de vinyle.

Par ailleurs, la première couche arrière peut être un film mono ou multicouche polymère.

De préférence, la première couche arrière comporte un film du type Tedlar®/ polytéréphtalate d'éthylène (PET)/Tedlar® (ou encore TPT). La première couche arrière peut encore comporter un film polymère à base de polyoléfines, notamment un film multicouche coextrudé à base de polypropylène (PP), polyamide (PA) et polyéthylène (PE), par exemple un film de la gamme Reflexolar® commercialisée par la société Renolit. La première couche arrière peut encore comporter un film polymère à base de polyoléfines greffées polyamides, par exemple un film obtenu à partir de la gamme Jurasol BS1 commercialisée par la société Juraplast.

De façon générale, la première couche arrière peut encore être réalisée comme selon la couche arrière d'un module photovoltaïque de conception classique, à savoir à base de verre, de métal ou de plastique, entre autres. Elle peut par exemple être formée par une structure polymérique à base d'un polymère isolant électrique, par exemple du type polytéréphtalate d'éthylène (PET), polyamide (PA) ou polypropylène (PP) pouvant être protégée par une ou des couches à base de polymères fluorés, comme le polyfluorure de vinyle (PVF) ou le polyfluorure de vinylidène (PVDF).

En outre, la première couche arrière peut présenter une épaisseur comprise entre 150 et 600 µm, notamment de l'ordre de 400 µm.

De façon avantageuse, la première couche arrière comporte une surface interne, au contact de l'ensemble encapsulant, sensiblement plane et une surface externe, au contact de la deuxième couche arrière, sensiblement plane.

La deuxième couche arrière peut préférentiellement être réalisée en au moins un matériau composite, notamment du type polymère/fibre de verre, par exemple résine époxy/fibre de verre.

De façon avantageuse, la deuxième couche arrière forme un renfort mécanique fixé à la première couche arrière. Autrement dit, elle forme une pièce assurant la tenue mécanique du module photovoltaïque.

Préférentiellement, les dimensions de la deuxième couche arrière sont au moins égales aux dimensions de la première couche arrière du module photovoltaïque.

Par ailleurs, la deuxième couche arrière peut préférentiellement comporter, sur sa surface externe, des reliefs faisant saillie depuis ladite surface externe, lesdits reliefs étant formés par des creux réalisés sur la surface interne de la deuxième couche arrière.

Ainsi, la deuxième couche arrière peut présenter une dimension verticale sur sa surface externe, provenant de la présence des reliefs en saillie, tandis que cette dimension verticale peut être absente sur sa surface interne, les creux étant non saillants relativement à cette surface interne. De façon avantageuse, de tels creux peuvent être remplis au moins partiellement par la couche adhésive située entre la première couche arrière et la deuxième couche arrière.

En outre, la deuxième couche arrière peut comporter une pluralité de points de fixation, destinés à permettre la fixation du module photovoltaïque à des traverses supports pour former un panneau de modules photovoltaïques, et configurés pour autoriser un écartement desdites traverses supports, par exemple compris entre 735 et 1045 mm.

Par ailleurs, selon un deuxième mode de réalisation de l'invention, la deuxième couche peut être constituée par une unique couche arrière tridimensionnelle, au contact de l'ensemble encapsulant, la surface interne de ladite couche arrière tridimensionnelle étant sensiblement plane et la surface externe de ladite couche arrière tridimensionnelle comportant les reliefs formant saillie relativement à ladite surface externe.

La couche arrière tridimensionnelle peut préférentiellement être réalisée en au moins un matériau composite, notamment du type polyamide/fibre de verre ou époxy/fibre de verre.

De façon avantageuse, la couche arrière tridimensionnelle forme un renfort mécanique fixé à l'ensemble encapsulant. Autrement dit, elle forme une pièce assurant la tenue mécanique du module photovoltaïque.

Par ailleurs, le module photovoltaïque présente avantageusement un poids surfacique inférieur ou égal à 7 kg/m², notamment inférieur ou égal à 6 kg/m², notamment encore inférieur ou égal à 5 kg/m². Préférentiellement, un tel module photovoltaïque comporte par exemple une soixantaine de cellules photovoltaïques en silicium cristallin de dimension 156 mm x 156 mm. L'invention n'est cependant pas limitée à un nombre fixe de cellules et pourrait s'appliquer à des modules présentant plus ou moins de cellules.

De plus, la deuxième couche arrière et la couche arrière tridimensionnelle, décrites précédemment, peuvent présenter chacune un poids surfacique inférieur ou égal à 2 kg/m², notamment inférieur ou égal à 1,8 kg/m², notamment encore inférieur ou égal à 1,5 kg/m².

En particulier, le poids surfacique de la deuxième couche arrière peut être inférieur ou égal au poids surfacique de la couche arrière tridimensionnelle.

Les reliefs de la surface externe de la deuxième couche peuvent avantageusement se présenter sous la forme de nervures longiformes.

L'épaisseur des nervures longiformes peut être comprise entre 5 et 60 mm, mieux entre 20 et 60 mm, préférentiellement encore entre 35 et 55 mm.

Selon un mode de réalisation de l'invention, les nervures longiformes comportent des nervures longiformes dites principales et des nervures longiformes dites secondaires, l'épaisseur des nervures secondaires étant strictement inférieure à l'épaisseur des nervures principales.

Dans ce cas, l'épaisseur des nervures principales peut être comprise entre 20 et 60 mm, préférentiellement entre 35 et 55 mm.

En outre, l'épaisseur des nervures secondaires peut être comprise entre 5 et 20 mm, préférentiellement entre 5 et 10 mm.

Par ailleurs, selon l'invention, au moins une partie des nervures longiformes, notamment des nervures principales, est située sur la périphérie de la surface externe de la deuxième couche de sorte à former un encadrement périphérique au moins partiel de la surface externe de la deuxième couche.

Un tel encadrement périphérique est partiel de sorte à prévoir un espace dépourvu de nervure longiforme pour l'intégration d'une boîte de jonction, destinée à recevoir le câblage nécessaire à l'exploitation du module photovoltaïque.

Par ailleurs, selon l'invention, au moins une première nervure longiforme, notamment une première nervure longiforme principale, s'étend depuis un premier coin de la périphérie de la surface externe de la deuxième couche et au moins une deuxième nervure longiforme, notamment une deuxième nervure longiforme principale, s'étend depuis un deuxième coin de la périphérie de la surface externe de la deuxième couche, les premier et deuxième coins étant notamment des coins successifs sur la périphérie de la surface externe de la deuxième couche, lesdites au moins une première nervure longiforme et une deuxième nervure longiforme s'étendant les unes en direction des autres de sorte à se croiser en au moins un point d'intersection. De façon avantageuse, ledit au moins un point d'intersection est sensiblement situé sur un axe passant par au moins deux points de fixation, destinés à permettre la fixation du module photovoltaïque à des traverses supports pour former un panneau de modules photovoltaïques, notamment situés sur la périphérie de la surface externe de la deuxième couche de façon opposée les uns par rapport aux autres.

De plus, l'ensemble encapsulant peut être réalisé à partir d'au moins un matériau polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy, entre autres.

De préférence, l'ensemble encapsulant peut être réalisé à partir de deux couches de poly(éthylène-acétate de vinyle) (EVA) d'épaisseur au moins égal à 200 µm, entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres.

Par ailleurs, les cellules photovoltaïques peuvent présenter une épaisseur comprise entre 1 et 300 µm.

Le module photovoltaïque peut en outre comporter une boîte de jonction, destinée à recevoir le câblage nécessaire à l'exploitation du module photovoltaïque.

Par ailleurs, quand bien même la première couche formant la face avant du module photovoltaïque est transparente, la deuxième couche formant la face arrière du module photovoltaïque peut être ou non transparente, étant notamment opaque.

En outre, l'espacement entre deux cellules photovoltaïques voisines, ou encore consécutives ou adjacentes, peut être supérieur ou égal à 1 mm, notamment compris entre 1 et 30 mm, et de préférence égal à 3 mm.

De plus, l'invention a encore pour objet, selon un autre de ses aspects, un procédé de réalisation d'un module photovoltaïque tel que défini précédemment, caractérisé en ce qu'il comporte l'étape de lamination à chaud, à une température supérieure ou égale à 120°C et pendant une durée du cycle de lamination d'au moins 10 minutes, d'au moins une partie des couches constitutives du module photovoltaïque.

Selon une première variante, le procédé peut être mis en œuvre pour la réalisation d'un module photovoltaïque selon le premier mode de réalisation de l'invention décrit précédemment, et peut alors comporter les deux étapes successives suivantes :
a) lamination à chaud, à une température supérieure ou égale à 120°C et pendant une durée du cycle de lamination d'au moins 10 minutes, de l'ensemble formé par la première couche, l'ensemble encapsulant, les cellules photovoltaïques et la première couche arrière pour l'obtention d'un laminé photovoltaïque,
b) assemblage de la deuxième couche arrière sur ledit laminé photovoltaïque, notamment sur la première couche arrière, par le biais d'une couche adhésive.

Selon une deuxième variante, le procédé peut encore être mis en œuvre pour la réalisation d'un module photovoltaïque selon le deuxième mode de réalisation de l'invention décrit précédemment, et peut alors comporter l'unique étape de lamination à chaud, à une température supérieure ou égale à 120°C et pendant une durée du cycle de lamination d'au moins 10 minutes, de l'ensemble formé par la première couche, l'ensemble encapsulant, les cellules photovoltaïques et la deuxième couche.

Par ailleurs, le procédé peut alors utiliser, au cours de cette unique étape de lamination, un contre-moule au contact de la surface externe de la deuxième couche, présentant une géométrie en relief inverse de la géométrie en relief formée par les reliefs sur la surface externe de la deuxième couche.

Le contre-moule peut être réalisé en au moins un matériau métallique, notamment en aluminium et/ou en acier.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- la figure 3 illustre, en coupe et en vue éclatée, un premier exemple de réalisation d'un module photovoltaïque conforme à l'invention,
- les figures 4A et 4B représentent partiellement respectivement, en vue de face, les surfaces interne et externe de la deuxième couche arrière du module photovoltaïque de la figure 3,
- les figures 5A à 5D illustrent, en coupe, en vue assemblée pour les figures 5B et 5D, en vue éclatée pour la figure 5A et partiellement éclatée pour la figure 5C, différentes étapes d'un premier exemple de procédé conforme à l'invention pour la réalisation d'un module photovoltaïque semblable à celui de la figure 3,
- la figure 6 illustre, en coupe et en vue éclatée, un deuxième exemple de réalisation d'un module photovoltaïque qui ne fait pas partie de la présente invention,
- la figure 7 représente, en vue de face, la surface externe de la couche arrière tridimensionnelle du module photovoltaïque de la figure 6, avec représentation des traverses supports, et
- les figures 8A et 8B illustrent, en coupe, en vue éclatée pour la figure 8A et en vue assemblée pour la figure 8B, différentes étapes d'un deuxième exemple de procédé pour la réalisation d'un module photovoltaïque semblable à celui de la figure 6.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure.

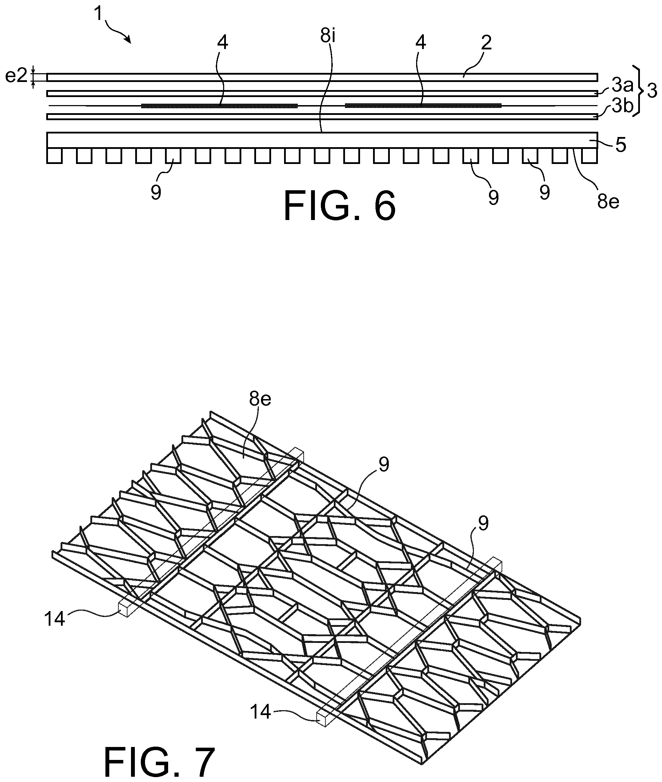

Les figures 3, 4A, 4B et 5A à 5D se réfèrent à un premier mode de réalisation de l'invention, tandis que les figures 6, 7, 8A et 8B se réfèrent à un deuxième mode de réalisation qui ne fait pas partie de la présente invention.

Pour chacun de ces deux modes de réalisation, on considère que les cellules photovoltaïques 4, interconnectées par des rubans en cuivre étamé soudés, sont des cellules « cristallines », c'est-à-dire qui sont à base de silicium mono ou multicristallin, et qu'elles présentent une épaisseur comprise entre 1 et 300 µm.

De plus, l'ensemble encapsulant 3 est choisi pour être réalisé à partir de deux couches de poly(éthylène-acétate de vinyle) (EVA) entre lesquelles sont disposées les cellules photovoltaïques 4, chaque couche étant d'épaisseur minimale égale à 300 µm, voire 200 µm. En variante, cet ensemble encapsulant 3 peut aussi être un élastomère thermoplastique comme décrit précédemment.

Par ailleurs, bien que non représenté sur les figures 3 à 8B, chaque module photovoltaïque 1 peut comporter une boîte de jonction, semblable à la boîte de jonction 7 représentée sur les figures 1 et 2, destinée à recevoir le câblage nécessaire à l'exploitation du module photovoltaïque 1. Cette boîte de jonction peut être réalisée en plastique ou en caoutchouc, étant complètement étanche.

Les cellules photovoltaïques 4, l'ensemble encapsulant 3 et la boîte de jonction 7 constituent ensemble les éléments dits « incompressibles » dans la constitution du module photovoltaïque 1. Ils présentent ensemble un poids surfacique d'environ 1,5 kg/m².

De façon avantageuse, l'invention prévoit un choix spécifique pour les matériaux formant les faces avant et arrière du module photovoltaïque 1, de sorte à obtenir un module photovoltaïque 1 léger, de poids surfacique inférieur ou égal à 7 kg/m², et préférentiellement inférieur ou égal à 6 kg/m², voire 5 kg/m². En particulier, l'invention permet la suppression de la couche de verre épais, d'environ 3 mm d'épaisseur, au niveau de la face avant et la suppression du cadre métallique du module photovoltaïque, qui représentent habituellement ensemble environ 80 % du poids total d'un module photovoltaïque.

Ainsi, dans les deux modes de réalisation décrits ci-après, la première couche 2 formant la face avant du module photovoltaïque 1 est une couche en verre d'épaisseur e2 inférieure ou égale à 1,1 mm, préalablement « durcie » grâce au procédé de trempe chimique.

Bien entendu, ces choix ne sont nullement limitatifs comme il a été décrit précédemment.

### Premier mode de réalisation

On se réfère tout d'abord à la figure 3 qui illustre, en coupe et en vue éclatée, un premier exemple de réalisation d'un module photovoltaïque 1 conforme à l'invention.

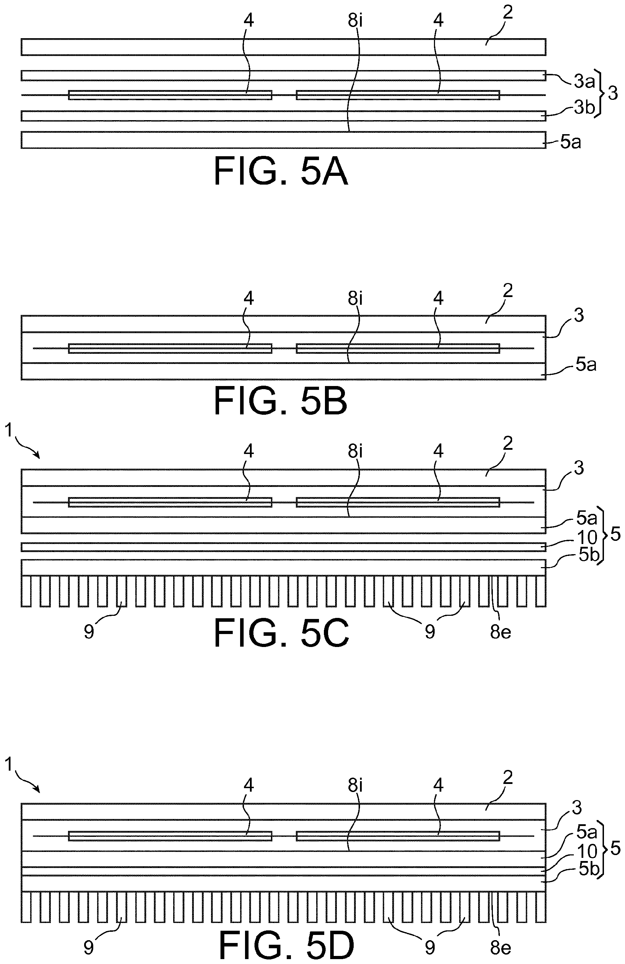

Il est à noter que la figure 3 correspond à une vue éclatée du module photovoltaïque 1 avant les étapes de lamination du premier exemple de procédé selon l'invention, décrit par la suite en référence aux figures 5A à 5D. Une fois les étapes de lamination réalisées, assurant un pressage à chaud et sous vide, les différentes couches sont en réalité superposées les unes aux autres.

Le module photovoltaïque 1 comporte ainsi une première couche 2 transparente en verre mince d'épaisseur inférieure ou égale à 1,1 mm, formant la face avant du module photovoltaïque 1 et destinée à recevoir un flux lumineux, une pluralité de cellules photovoltaïques 4 disposées côte à côte et reliées électriquement entre elles, et un ensemble encapsulant 3 la pluralité de cellules photovoltaïques 4.

Conformément à l'invention, le module photovoltaïque 1 comporte en outre une deuxième couche 5 formant la face arrière du module photovoltaïque 1, cette deuxième couche 5 étant dans cet exemple constituée par un ensemble d'une première couche arrière 5a, au contact de l'ensemble encapsulant 3, et d'une deuxième couche arrière tridimensionnelle 5b de sorte que la première couche arrière 5a est disposée entre l'ensemble encapsulant 3 et la deuxième couche arrière 5b.

La surface interne 8i, au contact de l'ensemble encapsulant 3, de la première couche arrière 5a est sensiblement plane de sorte à pouvoir permettre l'adhérence de la première couche arrière 5a à l'ensemble encapsulant 3 lors de l'opération de lamination décrite plus loin.

Au contraire, la surface externe 8e de la deuxième couche arrière 5b comporte des reliefs 9 formant saillie relativement à cette surface extérieure 8e, la surface extérieure 8e et les reliefs 9 définissant ensemble la surface extérieure arrière visible du module photovoltaïque 1. Ainsi, la surface externe 8e confère à la deuxième couche arrière 5b une forme de structure tridimensionnelle ou renfort tridimensionnel.

Par ailleurs, afin de permettre l'adhérence entre la première couche arrière 5a et la deuxième couche arrière 5b formant un renfort 3D, cet ensemble 5 formant la deuxième couche comporte encore une couche adhésive 10 entre la première couche arrière 5a et la deuxième couche arrière 5b. De façon privilégiée, cette couche adhésive 10 peut être une colle silicone.

La première couche arrière 5a peut être réalisée de façon semblable à la couche arrière d'un module photovoltaïque 1 classique. De façon préférentielle, la première couche arrière 5a est choisie pour être un film mono ou multicouche polymère, notamment du type Tedlar®/ polytéréphtalate d'éthylène (PET)/Tedlar®, encore appelé TPT.

L'épaisseur e5a de cette première couche arrière 5a peut être comprise entre 150 et 600 µm, étant notamment de l'ordre de 400 µm.

De façon avantageuse, la première couche arrière 5a comporte une surface interne 8i, au contact de l'ensemble encapsulant 3, sensiblement plane et une surface externe, au contact de la deuxième couche arrière 5b, sensiblement plane.

Par ailleurs, la deuxième couche arrière 5b, formant un renfort 3D, est avantageusement réalisée en un matériau composite, et en résine époxy/fibre de verre. Celle-ci permet d'assurer la tenue mécanique du module photovoltaïque 1.

Les dimensions de la deuxième couche arrière 5b sont avantageusement au moins égales à celles de la première couche 2 du module photovoltaïque 1.

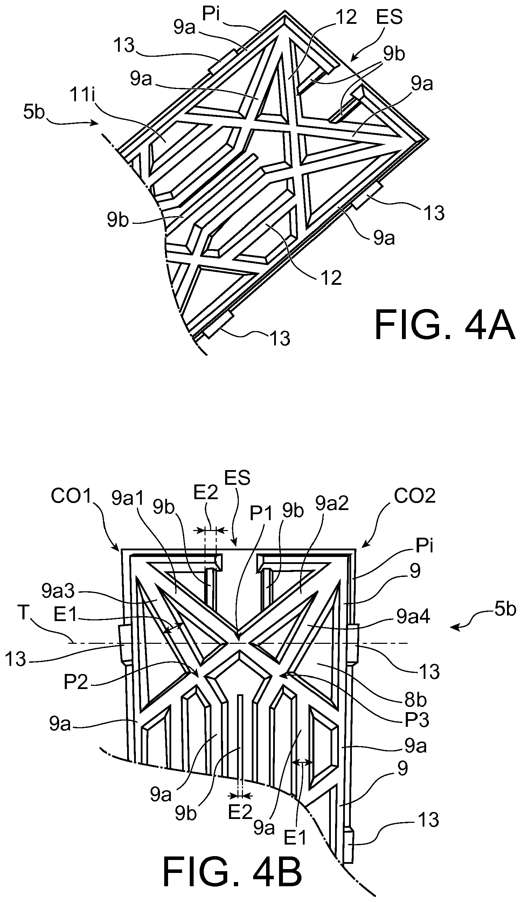

Les figures 4A et 4B représentent partiellement respectivement, en vue de face, les surfaces interne 11i et externe 8e de la deuxième couche arrière 5b du module photovoltaïque 1 de la figure 3.

Comme on peut le voir sur ces figures, la deuxième couche arrière 5b comporte, sur sa surface externe 8e, des reliefs 9 sous la forme de nervures longiformes faisant saillie depuis cette surface externe 8e. Ces reliefs 9 sont en réalité formés par des creux 12 de forme complémentaire réalisés sur la surface interne 11i de la deuxième couche arrière 5b. Ainsi, la deuxième couche arrière 5b présente une dimension verticale sur sa surface externe 8e, provenant de la présence des reliefs 9 en saillie.

Aussi, dans ce premier exemple de réalisation, le renfort 3D formé par la deuxième couche arrière 5b présentent des surfaces interne 11i et externe 8e non planes.

Par ailleurs, comme on peut le voir également en périphérie des surfaces interne 11i et externe 8e de la deuxième couche arrière 5b, celle-ci comporte encore une pluralité de points de fixation 13, destinés à permettre la fixation du module photovoltaïque 1 à des traverses supports, telles que celles 14 représentées sur la figure 7 concernant le deuxième mode de réalisation, pour former un panneau de modules photovoltaïques 1, et configurés pour autoriser un écartement desdites traverses supports, par exemple compris entre 735 et 1045 mm.

Dans cet exemple de réalisation des figures 4A et 4B, les nervures longiformes 9 se présentent sous la forme de deux type de nervures longiformes, à savoir d'une part des nervures longiformes dites principales 9a et d'autre part des nervures longiformes dites secondaires 9b.

De façon avantageuse, comme visible sur la figure 4B, les nervures longiformes principales 9a présentent une épaisseur E1 strictement supérieure à l'épaisseur E2 des nervures longiformes secondaires 9b.

En particulier, l'épaisseur E1 des nervures longiformes principales 9a est comprise entre 20 et 60 mm, et préférentiellement entre 35 et 55 mm. L'épaisseur E2 des nervures longiformes secondaires 9b est quant à elle comprise entre 5 et 20 mm, et préférentiellement entre 5 et 10 mm.

Il est à noter que, selon une variante de réalisation des figures 4A et 4B, les nervures longiformes 9 ne pourraient comporter que des nervures longiformes principales 9a et aucune nervure longiforme secondaire 9b.

Par ailleurs, comme visible sur les figures 4A et 4B, une partie des nervures longiformes principales 9a est située sur la périphérie Pi de la surface externe 8e de la deuxième couche arrière 5b de sorte à former un encadrement périphérique de celle-ci.

Cet encadrement périphérique est toutefois partiel car il comporte un espace ES, dépourvu de nervure longiforme 9, prévu pour l'intégration d'une boîte de jonction 7, telle que représentée à la figure 2, destinée à recevoir le câblage nécessaire à l'exploitation du module photovoltaïque 1.

En outre, dans cet exemple de réalisation des figures 4A et 4B, une première nervure longiforme principale 9a1 s'étend obliquement depuis un premier coin CO1 de la périphérie Pi de la surface externe 8e vers la portion centrale de la surface externe 8e et une deuxième nervure longiforme principale 9a2 s'étend obliquement depuis un deuxième coin CO2 de la périphérie Pi de la surface externe 8e vers la portion centrale de la surface externe 8e. Les premier CO1 et deuxième CO2 coins sont des coins successifs le long de la périphérie Pi de la surface externe 8e.

De façon avantageuse, ces première 9a1 et deuxième 9a2 nervures longiformes principales s'étendent en direction l'une de l'autre et viennent se croiser en un premier point d'intersection P1 qui se trouve situé sur un axe T reliant les points de fixation 13 situés les deux bords latéraux de la surface externe 8e.

Par ailleurs, une troisième nervure longiforme principale 9a3 s'étend également obliquement depuis le premier coin CO1 de la périphérie Pi de la surface externe 8e vers la portion centrale de la surface externe 8e et une quatrième nervure longiforme principale 9a4 s'étend également obliquement depuis le deuxième coin CO2 de la périphérie Pi de la surface externe 8e vers la portion centrale de la surface externe 8e.

De façon avantageuse, les deuxième 9a2 et troisième 9a3 nervures longiformes principales s'étendent en direction l'une de l'autre et viennent se croiser en un deuxième point d'intersection P2 qui se trouve situé sensiblement, c'est-à-dire à proximité, sur l'axe T reliant les points de fixation 13 situés les deux bords latéraux de la surface externe 8e.

De façon avantageuse encore, les première 9a1 et quatrième 9a4 nervures longiformes principales s'étendent en direction l'une de l'autre et viennent se croiser en un troisième point d'intersection P3 qui se trouve situé sensiblement, c'est-à-dire à proximité, sur l'axe T reliant les points de fixation 13 situés les deux bords latéraux de la surface externe 8e.

Les figures 5A à 5D illustrent, en coupe, en vue assemblée pour les figures 5B et 5D, en vue éclatée pour la figure 5A et partiellement éclatée pour la figure 5C, différentes étapes du premier exemple de procédé conforme à l'invention pour la réalisation d'un module photovoltaïque 1 semblable à celui de la figure 3.

La figure 5A illustre une structure photovoltaïque, avant lamination, comprenant la première couche 2, l'ensemble encapsulant 3 et les cellules photovoltaïques 4, et la première couche arrière 5a, selon une vue éclatée.

Sur la figure 5B, cette même structure est représentée après obtention du laminé photovoltaïque suite à une étape a) de lamination à chaud, à une température supérieure ou égale à 120°C et pendant une durée du cycle de lamination d'au moins 10 minutes.

La figure 5C illustre l'étape d'assemblage du laminé photovoltaïque de la figure 5B par collage de la deuxième couche arrière 5b sur la première couche arrière 5a par le biais de la couche adhésive 10.

La figure 5D illustre enfin le module photovoltaïque 1 obtenu conforme à l'invention.

Le module photovoltaïque 1 présente un poids surfacique inférieur à 7 kg/m². Après un test à la pression à 5400 Pa, la flèche au centre observée est inférieure à 40 mm et n'excède pas 25 mm.

### Deuxième mode de réalisation

On se réfère maintenant à la figure 6 qui illustre, en coupe et en vue éclatée, un deuxième exemple de réalisation d'un module photovoltaïque 1 qui ne fait pas partie de la présente invention.

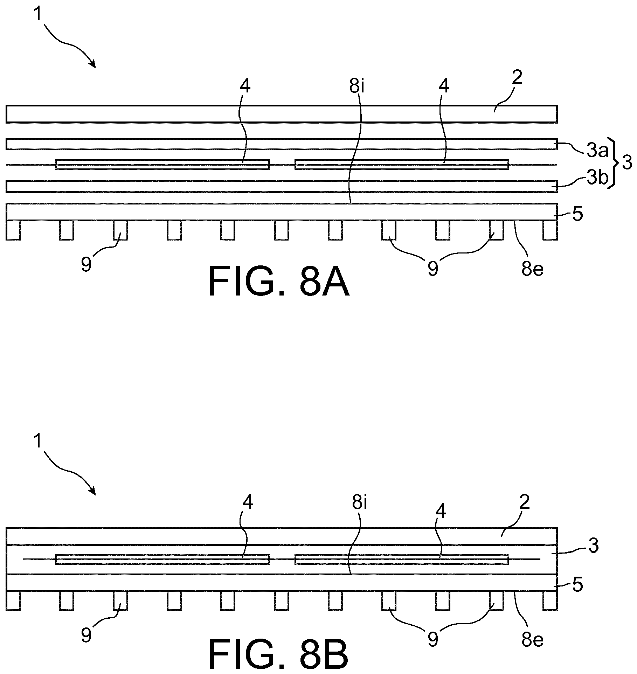

Il est à noter également que la figure 6 correspond à une vue éclatée du module photovoltaïque 1 avant les étapes de lamination du deuxième exemple de procédé selon l'invention, décrit par la suite en référence aux figures 8A et 8B. Une fois les étapes de lamination réalisées, assurant un pressage à chaud et sous vide, les différentes couches sont en réalité superposées les unes aux autres.

Le module photovoltaïque 1 comporte ainsi une première couche 2 transparente en verre mince d'épaisseur inférieure ou égale à 1,1 mm, formant la face avant du module photovoltaïque 1 et destinée à recevoir un flux lumineux, une pluralité de cellules photovoltaïques 4 disposées côte à côte et reliées électriquement entre elles, et un ensemble encapsulant 3 la pluralité de cellules photovoltaïques 4.

Le module photovoltaïque 1 comporte en outre une deuxième couche 5 formant la face arrière du module photovoltaïque 1, cette deuxième couche 5 étant dans cet exemple constituée par une unique couche arrière tridimensionnelle 5, au contact de l'ensemble encapsulant 3.

La surface interne 8i de cette couche arrière tridimensionnelle 5 est sensiblement plane afin de permettre son adhérence à l'ensemble encapsulant 3 lors de l'opération de lamination, tandis que la surface externe 8e de la couche arrière tridimensionnelle 5 comporte des reliefs 9 formant saillie relativement à cette surface externe 8e.

La figure 7 représente, en vue de face, la surface externe 8e de la couche arrière tridimensionnelle 5 du module photovoltaïque 1 de la figure 6, avec représentation également des traverses supports 14 permettant la fixation du module photovoltaïque 1 à un panneau photovoltaïque.

De façon avantageuse, cette couche arrière tridimensionnelle 5 forme une structure 3D, réalisée en un matériau composite, notamment du type polyamide/fibre de verre. Elle assure la tenue mécanique du module photovoltaïque 1.

La surface extérieure 8e de cette couche arrière tridimensionnelle 5 et les reliefs 9 définissent ensemble la surface extérieure arrière visible du module photovoltaïque 1.

A la différence de la deuxième couche arrière 5b du premier exemple de réalisation, représentée sur les figures 4A et 4B, la couche arrière tridimensionnelle 5 du deuxième exemple de réalisation, représentée sur la figure 7, présente une surface interne sensiblement plane et une surface externe 8e pourvue de reliefs 9. C'est la raison pour laquelle celle-ci peut adhérer à l'ensemble encapsulant 3 directement lors d'une opération de lamination, alors que la deuxième couche arrière 5b du premier exemple de réalisation ne peut pas l'être en raison de sa surface interne non plane, ce qui justifie la deuxième étape de collage avec une couche adhésive 10.

De plus, comme on peut le voir sur la figure 7, la couche arrière tridimensionnelle 5 comporte des reliefs 9 sous la forme de nervures longiformes faisant saillie depuis la surface externe 8e. Ainsi, la couche arrière tridimensionnelle 5 présente une dimension verticale sur sa surface externe 8e, provenant de la présence des reliefs 9 en saillie, tandis que cette dimension verticale est absente sur sa surface interne, sensiblement plane. Les nervures longiformes 9 peuvent présenter une épaisseur telle que mentionnée précédemment, et éventuellement comporter à la fois des nervures longiformes dites principales et des nervures longiformes dites secondaires, comme décrit auparavant.

Il est à noter que le motif général formé par les reliefs 9 sur la surface externe 8e de la couche arrière tridimensionnelle 5, visible sur la figure 7, pourrait également être utilisé comme motif général formé par les reliefs 9 sur la surface externe 8e de la deuxième couche arrière 5b, visible sur la figure 4B, et inversement.

Les figures 8A et 8B illustrent, en coupe, en vue éclatée pour la figure 8A et en vue assemblée pour la figure 8B, différentes étapes du deuxième exemple de procédé pour la réalisation d'un module photovoltaïque 1 semblable à celui de la figure 6.

La figure 8A illustre une structure photovoltaïque, avant lamination, comprenant la première couche 2, l'ensemble encapsulant 3 et les cellules photovoltaïques 4, et la couche arrière tridimensionnelle 5, selon une vue éclatée.

Sur la figure 8B, cette même structure est représentée après l'unique étape de lamination à chaud, à une température supérieure ou égale à 120°C et pendant une durée du cycle de lamination d'au moins 10 minutes, de cette structure pour obtenir le module photovoltaïque 1 selon le deuxième mode de réalisation.

Pendant cette unique étape de lamination, un contre-moule est préférentiellement utilisé au contact de la surface externe 8e de la deuxième couche 5 du fait de sa surface externe 8e non plane, puisque comportant les reliefs 9. Ce contre-moule présente une géométrie en relief inverse de la géométrie en relief formée par les reliefs 9 sur la surface externe 8e de la couche arrière tridimensionnelle 5. Il permet ainsi d'épouser la géométrie de l'empilement de couches dans le laminateur. Ce contre-moule est préférentiellement un bon conducteur thermique, étant ainsi réalisé en un matériau métallique, par exemple en aluminium et/ou en acier.

Par ailleurs, pour les deux modes de réalisation envisagés précédemment, la deuxième couche arrière 5b et la couche arrière tridimensionnelle 5 présentent préférentiellement chacune un poids surfacique inférieur ou égal à 2 kg/m², notamment inférieur ou égal à 1,8 kg/m², notamment encore inférieur ou égal à 1,5 kg/m². Le poids surfacique de la deuxième couche arrière 5b peut être inférieur ou égal au poids surfacique de la couche arrière tridimensionnelle 5.

De façon avantageuse, par l'utilisation d'une face avant en verre d'épaisseur inférieure ou égale à 1,1 mm, ou en polymère, le module photovoltaïque 1 peut avoir un poids surfacique inférieur ou égal à 7 kg/m², préférentiellement inférieur ou égal à 6 kg/m², voire 5 kg/m², soit au moins presque deux fois inférieur à celui d'un module photovoltaïque classique.

Ce gain de poids significatif peut permettre au module photovoltaïque 1 conforme à l'invention d'être installé sur des applications où un module standard d'environ 12 kg/m² ne pourrait pas être appliqué.

En outre, par l'utilisation de matériaux composites pour réaliser la deuxième couche 5, plus précisément la deuxième couche arrière 5b et la couche arrière tridimensionnelle 5, le module photovoltaïque 1 selon l'invention conserve ses propriétés mécaniques pour résister aux contraintes des normes IEC 61215 et IEC 61730.

De plus, le module obtenu est compatible avec une ligne industrielle de fabrication de modules photovoltaïques standards.

Bien entendu, l'invention n'est pas limitée à l'exemple de réalisation qui vient d'être décrit. Diverses modifications peuvent y être apportées par l'homme du métier.

## Revendications

1. Module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5) formant la face arrière du module photovoltaïque (1), la deuxième couche (5) comportant une surface interne (8i), au contact de l'ensemble encapsulant (3), et une surface externe (8e), opposée à la surface interne (8i), l'ensemble encapsulant (3) et la pluralité de cellules photovoltaïques (4) étant situés entre les première (2) et deuxième (5) couches,
la première couche (2) étant réalisée en verre et/ou en au moins un matériau polymère et présente une épaisseur (e2) inférieure ou égale à 1,1 mm,
la surface interne (8i) de la deuxième couche (5) étant sensiblement plane,
la deuxième couche (5) comportant en outre des reliefs (9) formant saillie relativement à la surface extérieure (8e) de la deuxième couche (5), la surface extérieure (8e) et les reliefs (9) définissant ensemble la surface extérieure arrière visible du module photovoltaïque (1), les reliefs (9) de la surface externe (8e) de la deuxième couche (5) se présentant sous la forme de nervures longiformes,
**caractérisé en ce qu'**au moins une partie des nervures longiformes (9) est située sur la périphérie (Pi) de la surface externe (8e) de la deuxième couche (5) de sorte à former un encadrement périphérique partiel de la surface externe (8e) de la deuxième couche (5), l'encadrement périphérique étant partiel de sorte à prévoir un espace (ES) dépourvu de nervure longiforme (9) pour l'intégration d'une boîte de jonction (7), destinée à recevoir le câblage nécessaire à l'exploitation du module photovoltaïque (1),
et **en ce qu'**au moins une première nervure longiforme (9a1, 9a3) s'étend depuis un premier coin (CO1) de la périphérie (Pi) de la surface externe (8e) de la deuxième couche (5) et au moins une deuxième nervure longiforme (9a2, 9a4) s'étend depuis un deuxième coin (CO2) de la périphérie (Pi) de la surface externe (8e) de la deuxième couche (5), les premier (CO1) et deuxième (CO2) coins étant des coins successifs sur la périphérie (Pi) de la surface externe (8e) de la deuxième couche (5), lesdites au moins une première nervure longiforme (9a1, 9a3) et une deuxième nervure longiforme (9a2, 9a4) s'étendant les unes en direction des autres de sorte à se croiser en au moins un point d'intersection (P1, P2, P3).

2. Module selon la revendication 1, **caractérisé en ce que** la première couche (2) est réalisée en au moins un matériau polymère choisi parmi : le polycarbonate (PC), le polyméthacrylate de méthyle (PMMA), notamment du PMMA monophasé (non choc) ou du PMMA multi-phasé (choc), par exemple du PMMA choc nanostructuré, le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), et/ou le Polychlorotrifluoroéthylène (PCTFE).

3. Module selon l'une des revendications précédentes, **caractérisé en ce que** la deuxième couche (5) est constituée par un ensemble (5) d'au moins une première couche arrière (5a), au contact de l'ensemble encapsulant (3), et une deuxième couche arrière tridimensionnelle (5b) de sorte que la première couche arrière (5a) est disposée entre l'ensemble encapsulant (3) et la deuxième couche arrière (5b), la surface interne de la deuxième couche (5) étant formée par la surface interne (8i), au contact de l'ensemble encapsulant (3), de la première couche arrière (5a) et la surface externe de la deuxième couche (5) étant formée par la surface externe (8e) de la deuxième couche arrière (5b), laquelle comporte les reliefs (9) formant saillie relativement à ladite surface externe (8e), la deuxième couche (5) comportant notamment une couche adhésive (10) entre la première couche arrière (5a) et la deuxième couche arrière (5b), pour permettre l'assemblage de la deuxième couche arrière (5b) à la première couche arrière (5a).

4. Module selon la revendication 3, **caractérisé en ce que** la première couche arrière (5a) est un film mono ou multicouche polymère et/ou **en ce que** la première couche arrière (5a) présente une épaisseur (e5a) comprise entre 150 et 600 µm, notamment de l'ordre de 400 µm.

5. Module selon la revendication 3 ou 4, **caractérisé en ce que** la deuxième couche arrière (5b) est réalisée en au moins un matériau composite, notamment du type polymère/fibre de verre, par exemple résine époxy/fibre de verre.

6. Module selon l'une quelconque des revendications 3 à 5, **caractérisé en ce que** la deuxième couche arrière (5b) comporte, sur sa surface externe (8e), des reliefs (9) faisant saillie depuis ladite surface externe (8e), lesdits reliefs (9) étant formés par des creux (12) réalisés sur la surface interne (11i) de la deuxième couche arrière (5b), et/ou **en ce que** la deuxième couche arrière (5b) comporte une pluralité de points de fixation (13), destinés à permettre la fixation du module photovoltaïque (1) à des traverses supports pour former un panneau de modules photovoltaïques, et configurés pour autoriser un écartement desdites traverses supports, notamment compris entre 735 et 1045 mm.

7. Module selon la revendication 1 ou 2, **caractérisé en ce que** la deuxième couche (5) est constituée par une unique couche arrière tridimensionnelle (5), au contact de l'ensemble encapsulant (3), la surface interne (8i) de ladite couche arrière tridimensionnelle (5) étant sensiblement plane et la surface externe (8e) de ladite couche arrière tridimensionnelle (5) comportant les reliefs (9) formant saillie relativement à ladite surface externe (8e), la couche arrière tridimensionnelle (5) étant notamment réalisée en au moins un matériau composite, notamment du type polyamide/fibre de verre.

8. Module selon l'une quelconque des revendications précédentes, **caractérisé en ce qu'**il présente un poids surfacique inférieur ou égal à 7 kg/m², notamment inférieur ou égal à 6 kg/m², notamment encore inférieur ou égal à 5 kg/m².

9. Module selon l'une quelconque des revendications précédentes, **caractérisé en ce que** l'épaisseur (E1, E2) des nervures longiformes (9) est comprise entre 5 et 60 mm, notamment entre 20 et 60 mm, notamment entre 35 et 55 mm.

10. Module selon l'une quelconque des revendications précédentes, **caractérisé en ce que** les nervures longiformes (9) comportent des nervures longiformes dites principales (9a) et des nervures longiformes dites secondaires (9b), l'épaisseur (E2) des nervures secondaires (9b) étant strictement inférieure à l'épaisseur (E1) des nervures principales (9a), l'épaisseur (E1) des nervures principales (9a) étant notamment comprise entre 20 et 60 mm, notamment entre 35 et 55 mm, et l'épaisseur (E2) des nervures secondaires (9b) étant notamment comprise entre 5 et 20 mm, notamment entre 5 et 10 mm.

11. Module selon l'une quelconque des revendications précédentes, **caractérisé en ce que** ledit au moins un point d'intersection (P1, P2, P3) est sensiblement situé sur un axe (T) passant par au moins deux points de fixation (13), destinés à permettre la fixation du module photovoltaïque (1) à des traverses supports pour former un panneau de modules photovoltaïques, notamment situés sur la périphérie (Pi) de la surface externe (8e) de la deuxième couche (5) de façon opposée les uns par rapport aux autres.

12. Procédé de réalisation d'un module photovoltaïque (1) selon l'une quelconque des revendications précédentes, **caractérisé en ce qu'**il comporte l'étape de lamination à chaud, à une température supérieure ou égale à 120°C et pendant une durée du cycle de lamination d'au moins 10 minutes, d'au moins une partie des couches constitutives (2, 3, 4, 5) du module photovoltaïque (1).

13. Procédé selon la revendication 12, **caractérisé en ce qu'**il est mis en œuvre pour la réalisation d'un module photovoltaïque (1) selon l'une quelconque des revendications 3 à 6, et **en ce qu'**il comporte les deux étapes successives suivantes :
a) lamination à chaud, à une température supérieure ou égale à 120°C et pendant une durée du cycle de lamination d'au moins 10 minutes, de l'ensemble formé par la première couche (2), l'ensemble encapsulant (3), les cellules photovoltaïques (4) et la première couche arrière (5a) pour l'obtention d'un laminé photovoltaïque,
b) assemblage de la deuxième couche arrière (5b) sur ledit laminé photovoltaïque, notamment sur la première couche arrière (5a), par le biais d'une couche adhésive (10).

14. Procédé selon la revendication 12, **caractérisé en ce qu'**il est mis en œuvre pour la réalisation d'un module photovoltaïque (1) selon la revendication 7, et **en ce qu'**il comporte l'unique étape de lamination à chaud, à une température supérieure ou égale à 120°C et pendant une durée de cycle de lamination d'au moins 10 minutes, de l'ensemble formé par la première couche (2), l'ensemble encapsulant (3), les cellules photovoltaïques (4) et la deuxième couche (5), le procédé utilisant notamment, au cours de l'unique étape de lamination, un contre-moule au contact de la surface externe (8e) de la deuxième couche (5), présentant une géométrie en relief inverse de la géométrie en relief formée par les reliefs (9) sur la surface externe (8e) de la deuxième couche (5), le contre-moule étant notamment réalisé en au moins un matériau métallique, notamment en aluminium et/ou en acier.

## Patentansprüche

1. Fotovoltaikmodul (1), enthaltend:
- eine erste transparente Schicht (2), die die Vorderseite des Fotovoltaikmoduls (1) bildet und dazu bestimmt ist, einen Lichtstrom zu empfangen,
- eine Vielzahl von fotovoltaischen Zellen (4), die nebeneinander angeordnet und elektrisch miteinander verbunden sind,
- eine Einkapselungsanordnung (3), die die Vielzahl der fotovoltaischen Zellen (4) einkapselt,
- eine zweite Schicht (5), die die Rückseite des Fotovoltaikmoduls (1) bildet, wobei die zweite Schicht (5) eine Innenfläche (8i) in Kontakt mit der Einkapselungsanordnung (3) und eine Außenfläche (8e) aufweist, die der Innenfläche (8i) gegenüberliegt, wobei die Einkapselungsanordnung (3) und die Vielzahl der fotovoltaischen Zellen (4) zwischen der ersten (2) und der zweiten (5) Schicht angeordnet sind,
wobei
die erste Schicht (2) aus Glas und/oder aus zumindest einem Polymermaterial besteht und eine Dicke (e2) geringer als oder gleich 1,1 mm aufweist,
die Innenfläche (8i) der zweiten Schicht (5) im Wesentlichen eben ist,
die zweite Schicht (5) ferner Erhebungen (9) aufweist, die in Bezug auf die Außenfläche (8e) der zweiten Schicht (5) vorstehen, wobei die Außenfläche (8e) und die Erhebungen (9) zusammen die sichtbare rückseitige Außenfläche des Fotovoltaikmoduls (1) definieren, wobei die Erhebungen (9) der Außenfläche (8e) der zweiten Schicht (5) in Form von langgestreckten Rippen vorliegen,
**dadurch gekennzeichnet, dass**
sich zumindest ein Teil der langgestreckten Rippen (9) am Umfang (Pi) der Außenfläche (8e) der zweiten Schicht (5) befindet, so dass sie einen partiellen Umfangsrahmen der Außenfläche (8e) der zweiten Schicht (5) bilden, wobei der Umfangsrahmen partiell ist, um einen von langgestreckten Rippen (9) freien Raum (ES) zum Aufnehmen eines Anschlusskastens (7) zu bilden, der dazu bestimmt ist, die für den Betrieb des Fotovoltaikmoduls (1) erforderliche Verdrahtung aufzunehmen, und dass
zumindest eine erste langgestreckte Rippe (9a1, 9a3) sich von einer ersten Ecke (CO1) des Umfangs (Pi) der Außenfläche (8e) der zweiten Schicht (5) erstreckt und zumindest eine zweite langgestreckte Rippe (9a2, 9a4) sich von einer zweiten Ecke (CO2) des Umfangs (Pi) der Außenfläche (8e) der zweiten Schicht (5) erstreckt, wobei die erste (CO1) und die zweite (CO2) Ecke aufeinanderfolgende Ecken am Umfang (Pi) der Außenfläche (8e) der zweiten Schicht (5) sind, wobei die zumindest eine erste langgestreckte Rippe (9a1, 9a3) und eine zweite langgestreckte Rippe (9a2, 9a4) sich so aufeinander zu erstrecken, dass sie sich an zumindest einem Schnittpunkt (P1, P2, P3) kreuzen.

2. Modul nach Anspruch 1,
**dadurch gekennzeichnet, dass**
die erste Schicht (2) aus zumindest einem Polymermaterial besteht, das ausgewählt ist aus: Polycarbonat (PC), Polymethylmethacrylat (PMMA), insbesondere einphasiges (nicht schlagzähes) PMMA oder mehrphasiges (schlagzähes) PMMA, zum Beispiel nanostrukturiertes schlagzähes PMMA, Polyethylenterephthalat (PET), Polyamid (PA), fluoriertem Polymer, insbesondere Polyvinylfluorid (PVF) oder Polyvinylidenfluorid (PVDF), Ethylen-Tetrafluorethylen (ETFE), Ethylen-Chlortrifluorethylen (ECTFE), Polytetrafluorethylen (PTFE) und/oder Polychlortrifluorethylen (PCTFE).

3. Modul nach einem der vorhergehenden Ansprüche,
**dadurch gekennzeichnet, dass**
die zweite Schicht (5) aus einer Anordnung (5) aus zumindest einer ersten rückseitigen Schicht (5a), die mit der Einkapselungsanordnung (3) in Kontakt steht, und einer zweiten dreidimensionalen rückseitigen Schicht (5b) besteht, so dass die erste rückseitige Schicht (5a) zwischen der Einkapselungsanordnung (3) und der zweiten rückseitigen Schicht (5b) angeordnet ist, wobei die Innenfläche der zweiten Schicht (5) von der mit der Einkapselungsanordnung (3) in Kontakt stehenden Innenfläche (8i) der ersten rückseitigen Schicht (5a) gebildet wird und die Außenfläche der zweiten Schicht (5) von der Außenfläche (8e) der zweiten rückseitigen Schicht (5b) gebildet wird, die die relativ zu der Außenfläche (8e) vorstehenden Erhebungen (9) aufweist, wobei die zweite Schicht (5) insbesondere eine Klebstoffschicht (10) zwischen der ersten rückseitigen Schicht (5a) und der zweiten rückseitigen Schicht (5b) umfasst, um das Anbringen der zweiten rückseitigen Schicht (5b) an die erste rückseitige Schicht (5a) zu ermöglichen.

4. Modul nach Anspruch 3,
**dadurch gekennzeichnet, dass**
die erste rückseitige Schicht (5a) ein ein- oder mehrschichtiger Polymerfilm ist, und/oder dass
die erste rückseitige Schicht (5a) eine Dicke (e5a) zwischen 150 und 600 µm, insbesondere in der Größenordnung von 400 µm, aufweist.

5. Modul nach Anspruch 3 oder 4,
**dadurch gekennzeichnet, dass**
die zweite rückseitige Schicht (5b) aus zumindest einem Verbundmaterial, insbesondere vom Typ Polymer/Glasfaser, beispielsweise Epoxidharz/Glasfaser, hergestellt ist.

6. Modul nach einem der Ansprüche 3 bis 5,
**dadurch gekennzeichnet, dass**
die zweite rückseitige Schicht (5b) auf ihrer Außenfläche (8e) Erhebungen (9) aufweist, die von der Außenfläche (8e) vorstehen, wobei die Erhebungen (9) mittels Vertiefungen (12) gebildet werden, die auf der Innenfläche (11i) der zweiten rückseitigen Schicht (5b) ausgebildet sind, und/oder dass die zweite rückseitige Schicht (5b) eine Vielzahl von Befestigungspunkten (13) aufweist, die dazu bestimmt sind, die Befestigung des Fotovoltaikmoduls (1) an Querträgern zu ermöglichen, um ein Paneel von Fotovoltaikmodulen zu bilden, und die dazu ausgelegt sind, eine Beabstandung der Querträger zu gestatten, die insbesondere zwischen 735 und 1045 mm beträgt.

7. Modul nach Anspruch 1 oder 2,
**dadurch gekennzeichnet, dass**
die zweite Schicht (5) aus einer einzigen dreidimensionalen rückseitigen Schicht (5) besteht, die in Kontakt mit der Einkapselungsanordnung (3) steht, wobei die Innenfläche (8i) der dreidimensionalen rückseitigen Schicht (5) im Wesentlichen eben ist und die Außenfläche (8e) der dreidimensionalen rückseitigen Schicht (5) die Erhebungen (9) aufweist, die in Bezug auf die Außenfläche (8e) vorstehen, wobei die dreidimensionale rückseitige Schicht (5) insbesondere aus zumindest einem Verbundmaterial, insbesondere vom Typ Polyamid/Glasfaser, hergestellt ist.

8. Modul nach einem der vorangehenden Ansprüche,
**dadurch gekennzeichnet, dass**
es ein Flächengewicht geringer als oder gleich 7 kg/m², insbesondere geringer als oder gleich 6 kg/m², insbesondere geringer als oder gleich 5 kg/m²,
aufweist.

9. Modul nach einem der vorangehenden Ansprüche,
**dadurch gekennzeichnet, dass**
die Dicke (E1, E2) der langgestreckten Rippen (9) zwischen 5 und 60 mm, insbesondere zwischen 20 und 60 mm, insbesondere zwischen 35 und 55 mm, beträgt.

10. Modul nach einem der vorangehenden Ansprüche,
**dadurch gekennzeichnet, dass**
die langgestreckten Rippen (9) so genannte langgestreckte Hauptrippen (9a) und so genannte langgestreckte Sekundärrippen (9b) aufweisen, wobei die Dicke (E2) der Sekundärrippen (9b) strikt geringer ist als die Dicke (E1) der Hauptrippen (9a), wobei die Dicke (E1) der Hauptrippen (9a) insbesondere zwischen 20 und 60 mm, insbesondere zwischen 35 und 55 mm, beträgt, und die Dicke (E2) der Sekundärrippen (9b) insbesondere zwischen 5 und 20 mm, insbesondere zwischen 5 und 10 mm, beträgt.

11. Modul nach einem der vorangehenden Ansprüche,
**dadurch gekennzeichnet, dass**
sich der zumindest eine Schnittpunkt (P1, P2, P3) im Wesentlichen auf einer Achse (T) befindet, die durch zumindest zwei Befestigungspunkte (13) verläuft, die dazu bestimmt sind, die Befestigung des Fotovoltaikmoduls (1) an Querträgern zu ermöglichen, um ein Paneel aus Fotovoltaikmodulen bilden, die insbesondere am Umfang (Pi) der Außenfläche (8e) der zweiten Schicht (5) entgegengesetzt zueinander angeordnet sind.

12. Verfahren zur Herstellung eines Fotovoltaikmoduls (1) nach einem der vorangehenden Ansprüche,
**dadurch gekennzeichnet, dass**
es den Schritt des Heißlaminierens von zumindest einem Teil der Schichten (2, 3, 4, 5), aus denen das Fotovoltaikmodul (1) besteht, bei einer Temperatur höher oder gleich 120°C für eine Dauer des Laminierungszyklus von zumindest 10 Minuten umfasst.

13. Verfahren nach Anspruch 12,
**dadurch gekennzeichnet, dass**
es für die Herstellung eines Fotovoltaikmoduls (1) nach einem der Ansprüche 3 bis 6 durchgeführt wird und dass es die beiden nachstehenden aufeinanderfolgenden Schritte umfasst:
a) Heißlaminieren der aus der ersten Schicht (2), der Einkapselungsanordnung (3), den fotovoltaischen Zellen (4) und der ersten rückseitigen Schicht (5a) gebildeten Anordnung bei einer Temperatur höher oder gleich 120°C für eine Dauer des Laminierungszyklus von zumindest 10 Minuten, um ein fotovoltaisches Laminat zu erhalten,
b) Anbringen der zweiten rückseitigen Schicht (5b) an das fotovoltaische Laminat, insbesondere an die erste rückseitige Schicht (5a), mittels einer Klebstoffschicht (10).

14. Verfahren nach Anspruch 12,
**dadurch gekennzeichnet, dass**
es für die Herstellung eines Fotovoltaikmoduls (1) nach Anspruch 7 durchgeführt wird und dass es den einzigen Schritt des Heißlaminierens der aus der ersten Schicht (2), der Einkapselungsanordnung (3), den fotovoltaischen Zellen (4) und der zweiten Schicht (5) gebildeten Anordnung bei einer Temperatur höher oder gleich 120°C für eine Dauer des Laminierungszyklus von zumindest 10 Minuten umfasst, wobei bei dem Verfahren insbesondere während des einzigen Laminierungsschritts eine Gegenform verwendet wird, die in Kontakt mit der Außenfläche (8e) der zweiten Schicht (2) steht und eine zu der durch die Erhebungen (9) an der Außenfläche (8e) der zweiten Schicht (5) gebildeten Reliefgeometrie inversen Reliefgeometrie aufweist, wobei die Gegenform insbesondere aus zumindest einem metallischen Material, insbesondere Aluminium und/oder Stahl, hergestellt ist.

## Claims

1. Photovoltaic module (1) comprising:
- a first transparent layer (2) forming the front face of the photovoltaic module (1), that will receive a light flux,
- a plurality of photovoltaic cells (4) arranged side by side and electrically connected together,
- an assembly (3) encapsulating the plurality of photovoltaic cells (4),
- a second layer (5) forming the rear face of the photovoltaic module (1), the second layer (5) comprising an inner surface (8i) in contact with the encapsulating assembly (3), and an outer surface opposite the inner surface (8i), the encapsulating assembly (3) and the plurality of photovoltaic cells (4) being located between the first layer and the second layer (5),
the first layer being made of glass (2) and/or at least one polymer material and its thickness (e2) is less than or equal to 1.1 mm,
the inner surface (8i) of the second layer (5) being approximately plane,
the second layer (5) also comprising raised portions (9) above the outer surface (8e) of the second layer (5), the outer surface (8e) and the raised portions (9) together defining the visible outer rear surface of the photovoltaic module (1), the relief (9) of the outer surface (8e) of the second layer (5) being in the form of elongated ribs,
**characterised in that** at least part of the elongated ribs (9) is located on the periphery (Pi) of the outer surface (8e) of the second layer (5) so as to form at least a partial peripheral frame of the outer surface (8e) of the second layer (5), this peripheral frame being partial so as to leave a space (ES) without any elongated ribs (9) for integration of a junction box (7), to contain the wiring necessary for use of the photovoltaic module (1),
and **in that** at least one first elongated rib (9a1, 9a3) extends from a first corner (CO1) of the periphery (Pi) of the outer surface (8e) of the second layer (5) and at least one second elongated rib (9a2, 9a4) extends from a second corner (CO2) of the periphery (Pi) of the outer surface (8e) of the second layer (5), the first corner (CO1) and the second corner (CO2) being successive corners around the periphery (Pi) of the outer surface (8e) of the second layer (5), said at least one first elongated rib (9a1, 9a3) and a second elongated rib (9a2, 9a4) extending towards each other so as to intersect at least at one intersection point (P1, P2, P3).

2. Module according to claim 1, **characterised in that** the first layer (2) is made from at least one polymer material, chosen from among polycarbonate (PC), polymethyl methacrylate (PMMA), particularly monophase (non-impact) PMMA or multi-phase (impact) PMMA, for example nanostructured impact PMMA, polyethylene terephthalate (PET), polyamide (PA), a fluorinated polymer and particularly polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE) and/or polychlorotrifluoroethylene (PCTFE).

3. Module according to one of the previous claims, **characterised in that** the second layer (5) is composed of an assembly (5) of at least one first rear layer (5a) in contact with the encapsulating assembly (3) and a second three-dimensional rear layer (5b) such that the first rear layer (5a) is placed between the encapsulating assembly and the second rear layer (5b), the inner surface of the second layer (5) being formed by the inner surface (8i), in contact with the encapsulating assembly (3), the first rear layer (5a) and the outer surface of the second layer (5) being formed by the outer surface (8e) of the second rear layer (5b), that comprises raised portions (9) projecting from said outer surface (8e),
said second layer (5) comprising particularly an adhesive layer (10) between the first rear layer (5a) and the second rear layer (5b), to assemble the second rear layer (5b) to the first rear layer (5a).

4. Module according to claim 3, **characterised in that** the first rear layer (5a) is a mono or multilayer polymer film, and/or **in that** the thickness (e5a) of the first rear layer (5a) is between 150 and 600 µm, particularly of the order of 400 µm.

5. Module according to claim 3 or 4, **characterised in that** the second rear layer (5b) is made from at least one composite material, particularly of the polymer/glass fibre type, for example epoxy resin / glass fibre.

6. Module according to any one of claims 3 to 5, **characterised in that** the second rear layer (5b) comprises raised portions (9) on its outer surface (8e) projecting from said outer surface (8e), said raised portions (9) being formed by recesses (12) made on the inner surface (11i) of the second rear layer (5b), and/or **in that** the second rear layer (5b) comprises a plurality of attachment points (13), that will fix the photovoltaic module (1) to support cross-pieces to form a panel of photovoltaic modules configured to enable a separation of said support cross-pieces, particularly between 735 and 1045 mm.

7. Module according to claim 1 or 2, **characterised in that** the second layer (5) is composed of a single three-dimensional rear layer (5) in contact with the encapsulating assembly (3), the inner surface (8i) of said three-dimensional rear layer (5) being approximately plane and the outer surface (8e) of said three-dimensional rear layer (5) forming portions (9) raised above said outer surface (8e), the three-dimensional rear layer (5) being particularly made from at least one composite material, particularly of the polyamide/glass fibre type.

8. Module according to any one of the previous claims, **characterised in that** its weight per unit area is less than or equal to 7 kg/m², particularly less than or equal to 6 kg/m², and more particularly less than or equal to 5 kg/m².

9. Module according to any one of the previous claims, **characterised in that** the thickness (E1, E2) of the elongated ribs (9) is between 5 and 60 mm, particularly between 20 and 60 mm, and particularly between 35 and 55 mm.

10. Module according to any one of the previous claims, **characterised in that** the elongated ribs 9 comprise so-called principal elongated ribs (9a) and so-called secondary elongated ribs (9b), the thickness (E2) of the secondary ribs (9b) being less than the thickness (E1) of the principal ribs (9a), the thickness (E1) of the principal ribs (9a) being particularly between 20 and 60 mm, and particularly between 35 and 55 mm, and the thickness (E2) of the secondary ribs (9b) being particularly between 5 and 20 mm, and particularly between 5 and 10 mm.

11. Module according to any one of the previous claims, **characterised in that** said at least one intersection point (P1, P2, P3) is located on an axis (T) passing through at least two attachment points (13) that will be used to fix the photovoltaic module (1) to support cross pieces to form a panel of photovoltaic modules, particularly around the periphery (Pi) of the outer surface (8e) of the second layer (5), facing each other.

12. Method for manufacturing a photovoltaic module (1) according to any one of the previous claims, **characterised in that** it comprises the step for hot lamination of at least some of the layers (2, 3, 4, 5) forming the photovoltaic module (1) at a temperature equal to or more than 120°C for a lamination cycle time of at least 10 minutes.

13. Method according to claim 12, **characterised in that** it is used to manufacture a photovoltaic module (1) according to any one of claims 3 to 6, and **in that** it comprises the following two successive steps:
a) hot lamination of the assembly formed by the first layer (2), the encapsulating assembly (3), the photovoltaic cells (4) and the first rear layer (5a) at a temperature greater than or equal to 120°C for a lamination cycle duration equal to at least 10 minutes, to obtain a photovoltaic laminate.
b) assembly of the second rear layer (5b) on said photovoltaic laminate, particularly on the first rear layer (5a), making use of an adhesive layer (10).

14. Method according to claim 12, **characterised in that** it is used to manufacture a photovoltaic module (1) according to claim 7, and **in that** it comprises the single hot lamination step of the assembly formed by the first layer (2), the encapsulating layer (3), the photovoltaic cells (4) and the second layer (5), at a temperature greater than or equal to 120°C for a lamination cycle time of at least 10 minutes, said method particularly using backing mould in contact with the outer surface (8e) of the second layer (5) with geometry inverse to the relief formed by the raised portions (9) on the outer surface (8e) of the second layer (5), during the single lamination step, said backing moule being particularly made of at least a metallic material, particularly aluminium and/or steel.
